# EUROPÄISCHE PATENTSCHRIFT

(11) **EP 1 212 931 B1**
(45) Veröffentlichungstag und Bekanntmachung des Hinweises auf die Patenterteilung: **05.03.2003**
(21) Anmeldenummer: 00967568.7
(22) Anmeldetag: 13.09.2000
(51) Int. Cl.: H05K 13/08, H05K 13/02

(54) **VORRICHTUNG ZUM ZUFÜHREN VON ELEKTRONISCHEN BAUTEILEN**
DEVICE FOR DELIVERING ELECTRONIC COMPONENTS
DISPOSITIF PERMETTANT D'AMENER DES COMPOSANTS ELECTRONIQUES

(30) Priorität: 15.09.1999 DE 19944290
(43) Veröffentlichungstag der Anmeldung: 12.06.2002
(73) Patentinhaber: SIEMENS AKTIENGESELLSCHAFT, 80333 München (DE)
(72) Erfinder: LÜCKEHE, Hans-Werner, 33154 Salzkotten (DE)
(86) Internationale Anmeldenummer: DE0003177
(87) Internationale Veröffentlichungsnummer: WO01020964

(56) Entgegenhaltungen:
- JP-A- 6 013 787
- JP-A- 7 038 291
- JP-A- 10 335 888
- US-A- 4 293 998
- US-A- 5 553 376

## Beschreibung

Die Erfindung betrifft eine Vorrichtung zum Zuführen von elektronischen Bauteilen, insbesondere SMD-Bauteilen, zu einer Bestückungseinheit, wobei aus einer Mehrzahl von Bauteilen gebildetes Stangengebinde einer eine Mehrzahl von Zuführschienen aufweisenden Zuführeinheit bereitgestellt werden.

Zur Herstellung von elektronischen Schaltungen sind Bestückungseinheiten bekannt, in denen Schaltungsträger mit elektronischen Bauteilen bestückt werden. Die elektronischen Bauteile werden üblicherweise als Gebinde bereitgehalten. Insbesondere hochwertige Bauteile, wie zum Beispiel integrierte Schaltungen, Stecker etc., werden als Stangengebinde der Bestückungseinheit zugeführt. Zum Rüsten der Bestückungseinheit werden die Gebinde üblicherweise in einer Zuführeinheit eines mobilen Wechseltisches bereitgehalten. Die Zuführeinheit weist eine Mehrzahl von Zufübrschienen auf, die korrespondierenden Zuleitungen der Bestückungseinheit zugeordnet sind. Da insbesondere beim Rüsten die Zuführeinheit mit Stangengebinden ortsfern von der Bestückungseinheit befüllt wird, kann es bei Unachtsamkeit der Bedienperson zu einer fehlerhaften Zuordnung des Gebindes zu der vorgegebenen Zuführschiene der Zuführeinheit kommen. Dies führt zu einer fehlerhaften Bestückung des Schaltungsträgers in der Bestückungseinheit.

US-A-4 293 998 offenbart eine Vorrichtung gemäß dem ersten Teil des Anspruchs 1.

Aufgabe der vorliegenden Erfindung ist es daher, eine Vorrichtung zum Zuführen von elektronischen Bauteilen derart weiterzubilden, daß eine sichere und zuverlässige Bestückung von elektronischen Bauteilen gewährleistet ist.

Zur Lösung dieser Aufgabe ist die Erfindung in Verbindung mit dem Oberbegriff des Patentanspruchs 1 dadurch gekennzeichnet, daß zu jeder Zuführschiene jeweils ein Stellmittel vorgesehen ist, das in Abhängigkeit von in einer Steuereinheit verarbeiteten Zuführsteuerungsdaten in eine die Zuführschiene blockierende Verriegelungsstellung oder in eine die Zuführschiene freigebende Entriegelungsstellung bringbar ist.

Der besondere Vorteil der erfindungsgemäßen Vorrichtung liegt darin, daß Rüst- und Nachfüllfehler sicher vermieden werden. Weiterhin können Maschinenstillstandszeiten reduziert bzw. vermieden werden, weil eine schnelle und sichere Zuordnung der Stangengebinde zu korrespondierenden Zuführschienen einer Zuführeinheit gewährleistet ist. Grundgedanke der Erfindung ist es, einen Kontrollmechanismus anzugeben, der eine fehlerhafte manuelle Zuordnung der Stangengebinde zu den jeweiligen Zuführschienen sicher verhindert. Erfindungsgemäß ist der Zuführeinheit eine Steuereinheit zugeordnet zur Erzeugung von Zuführsteuerungsdaten, die an jeweils einer Zuführschiene zugeordneten Stellmittel übertragen werden. In Abhängigkeit von dem Inhalt der Zuführsteuerungsdaten wird das Stellmittel betätigt, so daß es entweder in eine die Zuführung des Stangengebindes blockierende Verriegelungsstellung oder in eine dasselbe freigebende Entriegelungsstellung verbracht wird.

Nach einer Weiterbildung der Erfindung weist die Steuereinheit Mittel zum Erfassen und Verarbeiten von das Stangengebinde betreffende bauteilebezogene Daten bzw. Rüstinformationen beinhaltende bestückungsbezogene Daten auf. Durch Eingabe der bauteilebezogenen Daten eines bestimmten Stangengebindes kann unter Berücksichtigung der bestückungsbezogenen Daten die Zuführschiene für das entsprechende Stangengebinde ermittelt werden. Durch Abgabe von Zuführsteuerungsdaten wird das Stellmittel der korrespondierenden Zuführschiene in eine Entriegelungsstellung verbracht, so daß das Stangengebinde in einem Einführbereich der Zuführschiene eingesetzt werden kann. Vorteilhaft können die bauteilebezogene Daten des Stangengebindes als Strichcode-Markierung auf dem Gebinde aufgebracht sein, so daß sie mittels einer mit der Steuereinheit verbundenen Leseeinheit in die Steuereinheit einlesbar sind. Dadurch, daß die bauteilebezogenen Daten fest mit dem Gebinde gekoppelt sind, wird eine Verwechslung der Gebinde bei der Zuordnung zu den Zuführschienen sicher vermieden.

Nach einer weiteren Ausführungsform der Erfindung können die bauteilebezogenen Daten auch in einem Speicher einer Chipkarte abgespeichert sein, wobei die Chipkarte über ein Koppelelement fest mit einem entsprechenden Stangengebinde verbunden ist. Durch die Ausbildung als Chipkarte kann eine Änderung der bauteilebezogenen Daten auf elektronisch einfachem Wege herbeigeführt werden.

Nach einer bevorzugten Ausführungsform der Erfindung ist das Stellelement als elektromagnetisches Stellelement ausgebildet und verfügt über einen Verriegelungszylinder, der quer zur durch die Zuführschiene vorgegebenen Förderrichtung verschiebbar ausgebildet ist. Durch elektrische Ansteuerung kann diese einfach in eine Verriegelungs- bzw. Entriegelungsstellung verbracht werden.

Nach einer Weiterbildung der Erfindung sind die Stellelemente jeweils über eine Steckverbindung mit einer gemeinsamen Verteilerleiste verbunden. Die Verteilerleiste ist vorzugsweise mit der Steuereinheit mechanisch und elektrisch verbunden. Vorteilhaft ergibt sich hierdurch ein modularer Aufbau der erfindungsgemäßen Vorrichtung, die an eine vorhandene Zuführeinheit einfach montierbar ist.

Nach einer Weiterbildung der Erfindung weist das Stellelement und/oder die Verteilerleiste Leuchtmittel auf, mittels derer insbesondere bei einer Vielzahl von Zuführschienen das Erkennen der Zuordnung durch die Bedienperson erleichtert wird.

Weitere Vorteile der Erfindung ergeben sich aus den weiteren Unteransprüchen.

Ein Ausführungsbeispiel der Erfindung wird nachfolgend anhand der Zeichnungen näher beschrieben.

Es zeigen:
- Figur 1: eine perspektivische Darstellung einer erfindungsgemäßen Vorrichtung und
- Figur 2: eine vergrößerte Darstellung eines Stellelementes in einer Verriegelungsstellung.

Die erfindungsgemäße Vorrichtung findet insbesondere Einsatz bei der Zuführung von elektronischen Bauteilen als Stangengebinde. Vorzugsweise sind in einem Stangengebinde eine Mehrzahl von komplexeren Bauteilen eines Typs, wie integrierte Schaltungen (IC), BGA-Bauteilen (Ball-Grid-Array-Bauteile) etc. zusammengefaßt. Die Stangengebinde mit diesen SMD-Bauteilen müssen auf einem vorgegebenen Förderweg einer nicht dargestellten Bestückungseinheit zur Bestückung eines Schaltungsträgers zugeführt werden.

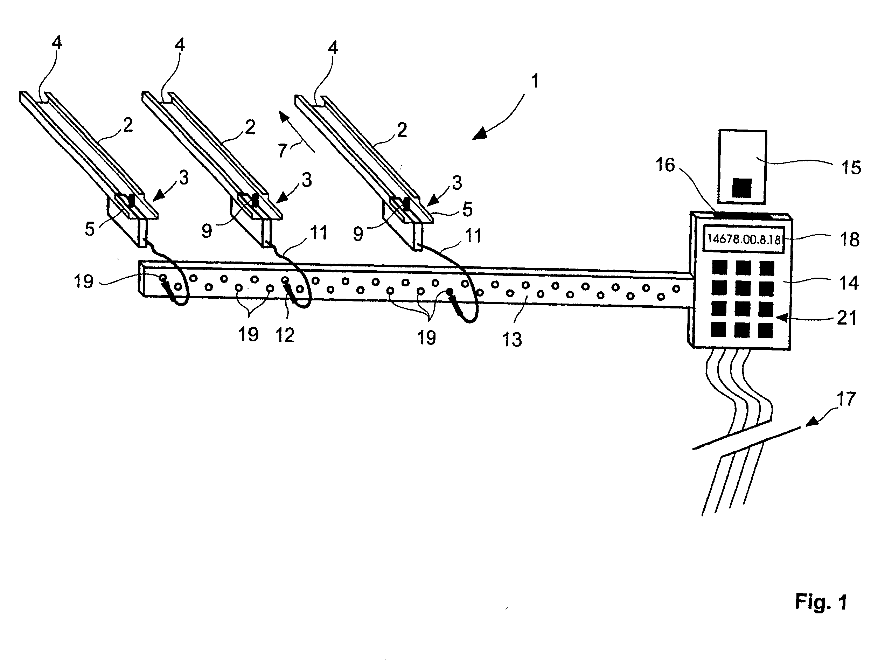

Ein in Figur 1 schematisch dargestellte Zuführeinheit ist auf einem nicht dargestellten Wechseltisch plaziert, der verfahrbar ausgebildet ist, so daß das Rüsten der SMD-Bauteile an einem zu der Bestückungseinheit entfernten Ort erfolgen kann. Die zuführeinheit 1 weist eine Mehrzahl von Zuführschienen 2 auf, die jeweils als im Querschnitt U-förmige Profile ausgebildet sind. Die Zuführschienen 2 sind parallel und beabstandet zueinander angeordnet. An einem zur Bestückungseinheit abgewandten Ende weisen die Zuführschienen 2 jeweils einen Einführbereich 3 auf, der lediglich von einer Basisfläche 4 abragende Seitenführungen 5 aufweist. In diesem Einführbereich 3 werden Stangengebinde 6 jeweils manuell angelegt und in eine zur Erstreckung der Zuführschiene 2 parallele Lage gebracht, so daß das Stangengebinde 6 entlang eines Förderweges 7 in der Zuführschiene 2 verschoben werden kann. Das Stangengebinde ist quaderförmig ausgebildet, wobei die Querschnittskontur des Stangengebindes 6 derart ausgebildet ist, daß es mit Spiel innerhalb der Zuführschiene 2 verschiebbar ist.

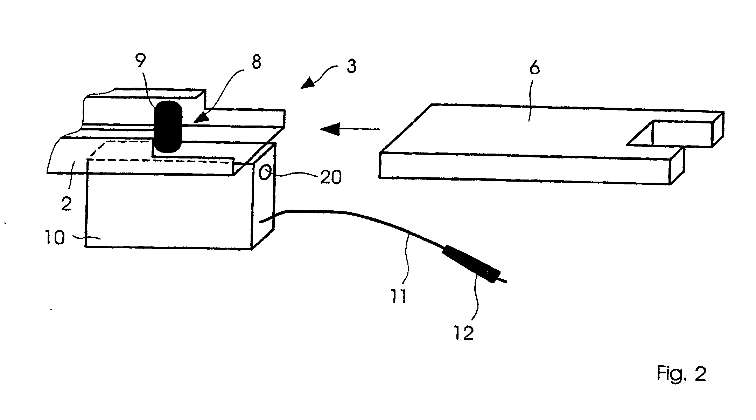

In dem Einführbereich 3 weist die Basisfläche 4 eine Bohrung 8 auf, zu der koaxial ein Verriegelungszylinder 9 verstellbar angeordnet ist. Der Verriegelungszylinder 9 ist Bestandteil eines elektromagnetischen Stellelementes 10, das unterhalb der Zuführschiene 2 mittels nicht dargestellter Befestigungsmittel angebracht ist. Vorzugsweise liegt eine Oberseite des Stellelementes 10 unmittelbar an einer Unterseite der Basisfläche 4 an, siehe Figur 2.

Der Verriegelungszylinder 9 ist als Hubmagnet ausgebildet, der infolge einer elektrischen Betätigung in eine die Zuführschiene 2 sperrende Verriegelungsstellung und in eine die Zuführschiene 2 freigebende Entriegelungsstellung bringbar ist. Zur elektrischen Ansteuerung des Stellelementes 10 ist dasselbe mittels eines Kabels und eines sich an dem Ende desselben anschließenden Steckelementes 12 mit einer Verteilerleiste 13 elektrisch und mechanisch verbunden. Die Verteilerleiste 13 erstreckt sich quer zu den Zuführschienen 2 in einem Bereich, der dem Einführbereich 3 der Zuführschienen 2 vorgelagert ist. Die Verteilerleiste 13 ist mechanisch und elektrisch mit einer seitlich angeordneten Steuereinheit 14 verbunden, in der eine Auswerteelektronik mit einem Mikrokontroller und einem Festwertspeicher angeordnet ist. In dem Festwertspeicher ist ein Vergleichsprogramm zur Feststellung der Zuordnung des Gebindes zu einer der Zuführschienen 2 gespeichert.

In der Steuereinheit 14 ist ein Kartenlesegerät integriert, mittels dessen auf einer Chipkarte 15 gespeicherte Informationen ausgelesen werden können. Die Chipkarte 15 ist über ein nicht dargestelltes Koppelelement fest, aber lösbar mit einem Stangengebinde 6 verbunden. Die Chipkarte 15 enthält bauteilebezogene Daten, insbesondere Teilenummern etc. über die in dem Stangengebinde 6 enthaltenen Bauteile.

Zum Rüsten der Bauteile bzw. Nachfüllen derselben wird die mechanisch mit dem Stangengebinde 6 verbundene Chipkarte 15 in einen Schlitz 16 der Steuereinheit 14 eingeschoben, so daß die bauteilebezogenen Daten ausgelesen und in der Auswerteelektronik verarbeitet werden können. Die bauteilebezogenen Daten werden in der Auswerteelektronik der Steuereinheit 14 auf Übereinstimmung mit jeweils den Zuführschienen 2 zugeordneten bestückungsbezogenen Daten auf Übereinstimmung geprüft. Die bestückungsbezogenen Daten beinhalten Rüstinformationen, die Angaben über eine Zuordnung von zu verarbeitenden Bauteilen zu der den jeweiligen Zuführschienen 2, mittels derer die Bauteile an einem vorgegebenen Ort der Bestückungseinheit zugeführt werden, enthalten. Diese Rüstinformationen sind daher abhängig von der jeweiligen Bestückungseinheit und können mittels einer Datenschnittstelle 17 von einem Linienleitrechner der Steuereinheit 14 zugeführt werden. Alternativ können diese bestückungsbezogenen Daten auch mittels einer weiteren Master-Chipkarte durch Einführen in den Schlitz 16 eingelesen werden.

Nach dem Einführen der die bauteilebezogenen Daten aufweisenden Chipkarte 15 wird in einem Display 18 die Kennung für die Bauteile des entsprechenden Stangengebindes 6 angezeigt. Somit ist die Bedienperson informiert über den Inhalt des Stangengebindes 6. Durch Vergleich der bauteilebezogene Daten mit den bestückungsbezogenen Daten in der Auswerteelektronik werden in dieser Zuführsteuerungsdaten erzeugt, die als Zuführsteuerungssignale sequentiell an die Verteilerleiste 13 übergeben werden. Dabei wird das Zuführsteuerungssignal an eine solche Steckeinrichtung 19 abgegeben, die zu der Zuführschiene 2 korrespondiert, in die das entsprechende Stangengebinde 6 eingeführt werden soll. Durch dieses Zuführsteuerungssignal wird das entsprechende Stellelement 10 betätigt, derart, daß der Verriegelungszylinder 9 aus seiner sperrenden Ausgangsstellung in die die Zuführschiene 2 freigebende Entriegelungsstellung verbracht wird. Der Einführbereich 3 der Zuführschiene 2 ist nunmehr freigelegt, so daß das entsprechende Stangengebinde 6 in diese durch eine Bedienperson eingeführt werden kann.

Zur leichteren Erkennbarkeit der Stellung des Verriegelungszylinders 9 ist den Stellelementen 10 jeweils eine Leuchtdiode 20 zugeordnet, die an einer Vorderseite des Stellelementes 10 positioniert ist. Bei Freigabe einer Zuführschiene 2 leuchtet die Leuchtdiode 20 auf und signalisiert der Bedienperson, welcher Zuführschiene 2 sie das Gebinde 6 zuführen soll. Nach dem Einführen des Gebindes 6 kann dasselbe von der Chipkarte 15 entkoppelt werden. Alternativ kann das Gebinde 6 auch unmittelbar nach Einführen der Chipkarte 15 in den Schlitz 16 der Steuereinheit 14 entkoppelt werden. Zusätzlich kann eine weitere Leuchtdiode angeordnet sein, die den Betriebszustand des Stellelementes 10 signalisiert. Die Ausgangsstellung des Verriegelungszylinders 9 wird vorzugsweise mittels einer Federkraft bewirkt, so daß lediglich ein elektrische Signal zu Freigabe der Zuführschiene 2 erforderlich ist.

Nach einer alternativen Ausführungsform der Erfindung können die bauteilebezogenen Daten auch als Strichcode-Markierung auf dem Stangengebinde 6 aufgebracht sein. Durch ein in einer die gleiche Auswerteelektronik des vorhergehenden Ausführungsbeispiels aufweisenden Steuereinheit integrierten Leseeinheit können die bauteilebezogenen Daten einfach eingelesen und der Auswerteelektronik zur Verarbeitung zur Verfügung gestellt werden. Im Anschluß daran kann das Stangengebinde sofort der entsprechenden Zuführschiene 2 zugeführt werden. Vorteilhaft ermöglicht diese Ausführungsform eine vereinfachte Zuordnung der Stangengebinde 6 zu den entsprechenden Zuführschienen 2.

Ein Tastenfeld 21 mit Tasten dient zur Eingabe von Servicedaten oder dergleichen.

## Patentansprüche

1. Vorrichtung zum Zuführen von elektronischen Bauteilen, insbesondere SMD-Bauteilen, zu einer Bestückungseinheit, wobei aus einer Mehrzahl von Bauteilen gebildete Stangengebinde (6) einer eine Mehrzahl von Zuführschienen (2) aufweisenden Zuführeinheit bereitgestellt werden, **dadurch gekennzeichnet, daß** zu jeder Zuführschiene (2) jeweils ein Stellmittel (10) vorgesehen ist, das in Abhängigkeit von in einer Steuereinheit (14) verarbeiteten Zuführsteuerungsdaten in eine die Zuführschiene (2) blockierende Verriegelungsstellung oder in eine die Zuführschiene (2) freigebende Entriegelungsstellung bringbar ist.

2. Vorrichtung nach Anspruch 1, **dadurch gekennzeichnet, daß** die Steuereinheit (14) Mittel zum Erfassen und Verarbeiten von das Stangengebinde (6) betreffende bauteilebezogene Daten aufweist.

3. Vorrichtung nach Anspruch 1 oder 2, **dadurch gekennzeichnet, daß** die Steuereinheit (14) Mittel zum Feststellen einer Zuweisung des Stangengebindes (6) zu einer vorgegebenen Zuführschiene (2) aufweist, wobei aus dem Vergleich von vorgegebenen bestückungsbezogenen Daten mit jeweils einem Stangengebinde (6) zugeordneten bauteilebezogene Daten die Zuführsteuerungsdaten erzeugbar sind.

4. Vorrichtung nach einem der Ansprüche 1 bis 3, **dadurch gekennzeichnet, daß** die Steuereinheit (14) mit einer Mehrzahl von Zuführschienen (2) koppelbar ist, derart, daß die Zuführsteuerungsdaten sequentiell zu den Stellmitteln übertragbar sind.

5. Vorrichtung nach einem der Ansprüche 1 bis 4, **dadurch gekennzeichnet, daß** die Steuereinheit (14) eine Auswerteelektronik aufweist, in der die dem Stangengebinde (6) zugeordneten bauteilebezogenen Daten auf Übereinstimmung mit den vorgegebenen, den Zuführschienen (2) zugeordneten bestückungsbezogenen Daten überprüfbar sind.

6. Vorrichtung nach einem der Ansprüche 1 bis 5, **dadurch gekennzeichnet, daß** die Auswerteelektronik einen Mikrokontroller mit einem Festwertspeicher aufweist, in dem ein Vergleichsprogramm zur Überprüfung der Übereinstimmung der bauteilebezogenen Daten und der bestückungsbezogenen Daten gespeichert ist.

7. Vorrichtung nach einem der Ansprüche 1 bis 6, **dadurch gekennzeichnet, daß** das Stellmittel (12) als elektromagnetisches Stellelement ausgebildet ist.

8. Vorrichtung nach einem der Ansprüche 1 bis 7, **dadurch gekennzeichnet, daß** das elektronische Stellelement (10) einen Verriegelungszylinder (9) aufweist, der quer zur Erstreckung der Zuführschiene (2) verschiebbar angeordnet ist, wobei er sich in der Verriegelungsstellung des Stellelementes (10) in einer den Förderweg (7) auf der Zuführschiene (2) versperrenden Aufahrposition befindet.

9. Vorrichtung nach einem der Ansprüche 1 bis 8, **dadurch gekennzeichnet, daß** die von der Steuereinheit (14) erzeugten Zuführsteuerungsdaten mittels einer elektrischen Verbindung zu den jeweiligen Stellelementen (10) übertragbar sind.

10. Vorrichtung nach einem der Ansprüche 1 bis 9, **dadurch gekennzeichnet, daß** die Stellelemente (10) mittels einer gemeinsamen Verteilerleiste (13) mit der Steuereinheit (14) elektrisch verbunden sind.

11. Vorrichtung nach einem der Ansprüche 1 bis 10, **dadurch gekennzeichnet, daß** die Verteilerleiste (13) eine zu der Anzahl der Zuführschienen (2) korrespondierende Anzahl von Steckeinrichtungen (19) aufweist, die jeweils mit korrespondierenden, an den Stellelementen (10) angeordneten Steckelementen (12) verbindbar sind.

12. Vorrichtung nach einem der Ansprüche 1 bis 11, **dadurch gekennzeichnet, daß** die Verteilerleiste (13) quer zur Erstreckung der Zuführschienen (2) und an einem der Bestückungseinheit abgewandten Ende der Zuführeinheit (1) angeordnet ist.

13. Vorrichtung nach einem der Ansprüche 1 bis 12, **dadurch gekennzeichnet, daß** das Stellelement (10) und/oder die Verteilerleiste (13) Leuchtmittel (20) umfaßt, derart, daß die Zuordnung des betreffenden Stangengebindes (6) zu der korrespondierenden Zuführschiene (2) erkennbar ist.

14. Vorrichtung nach einem der Ansprüche 1 bis 13, **dadurch gekennzeichnet, daß** das Leuchtmittel als Leuchtdiode (20) ausgebildet ist.

15. Vorrichtung nach einem der Ansprüche 1 bis 14, **dadurch gekennzeichnet, daß** die bauteilebezogenen Daten als Strichcode-Markierung auf dem Stangengebinde (6) in codierter Form aufgebracht sind, wobei die Strichcode-Markierung mittels einer mit der Steuereinheit (14) verbundenen Leseeinheit in die Steuereinheit (14) einlesbar ist.

16. Vorrichtung nach einem der Ansprüche 1 bis 14, **dadurch gekennzeichnet, daß** die bauteilebezogenen Daten in einem Speicher einer Chipkarte (15) abspeicherbar sind und daß sie mittels einer in der Steuereinheit (14) integrierten Leseeinheit auslesbar sind.

## Claims

1. Device for delivering electronic components, in particular SMD components, to an insertion unit, bar units (6) formed from a plurality of components being provided to a delivery unit having a plurality of delivery rails (2), **characterized in that** each delivery rail (2) is in each case provided with actuating means (10) which, depending on delivery control data processed in a control unit (14), can be brought into a locked position in which the delivery rail (2) is blocked or into an unlocked position in which the delivery rail (2) is released.

2. Device according to Claim 1, **characterized in that** the control unit (14) has means for acquiring and processing component-related data relating to the bar unit (6).

3. Device according to Claim 1 or 2, **characterized in that** the control unit (14) has means for establishing an allocation of the bar unit (6) to a predefined delivery rail (2), it being possible for the delivery control data to be generated from the comparison between predefined fitting-related data and component-related data in each case assigned to a bar unit (6).

4. Device according to one of Claims 1 to 3, **characterized in that** the control unit (14) can be coupled to a plurality of delivery rails (2) in such a way that the delivery control data can be transmitted sequentially to the actuating means.

5. Device according to one of Claims 1 to 4, **characterized in that** the control unit (14) has evaluation electronics, in which the component-related data assigned to the bar unit (6) can be checked for agreement with the predefined, fitting-related data assigned to the delivery rails (2).

6. Device according to one of Claims 1 to 5, **characterized in that** the evaluation electronics have a microcontroller with a read-only memory, in which there is stored a comparison program for checking the agreement between the component-related data and the fitting-related data.

7. Device according to one of Claims 1 to 6, **characterized in that** the actuating means (12) is designed as an electromagnetic actuating element.

8. Device according to one of Claims 1 to 7, **characterized in that** the electronic actuating element (10) has a locking cylinder (9), which is arranged such that it can be displaced transversely with respect to the extent of the delivery rail (2), being located in an extended position blocking the delivery path (7) on the delivery rail (2) when the actuating element (10) is in the locked position.

9. Device according to one of Claims 1 to 8, **characterized in that** the delivery control data generated by the control unit (14) can be transmitted to the respective actuating elements (10) by means of an electrical connection.

10. Device according to one of Claims 1 to 9, **characterized in that** the actuating elements (10) are connected electrically, by means of a common distributor strip (13), to the control unit (14).

11. Device according to one of Claims 1 to 10, **characterized in that** the distributor strip (13) has a number of plug-in devices (19) corresponding to the number of delivery rails (2), it being possible for said plug-in devices (19) in each case to be connected to corresponding plug-in elements (12) arranged on the actuating elements (10).

12. Device according to one of Claims 1 to 11, **characterized in that** the distributor strip (13) is arranged transversely with respect to the extent of the delivery rails (2) and at an end of the delivery unit (1) facing away from the insertion unit.

13. Device according to one of Claims 1 to 12, **characterized in that** the actuating element (10) and/or the distributor strip (13) comprises light-emitting means (20), in such a way that the assignment of the relevant bar unit (6) to the corresponding delivery rail (2) can be detected.

14. Device according to one of Claims 1 to 13, **characterized in that** the light-emitting means is designed as a light-emitting diode (20).

15. Device according to one of Claims 1 to 14, **characterized in that** the component-related data are applied to the bar unit (6) in encoded form as a bar code marking, it being possible for the bar code marking to be read into the control unit (14) by means of a reading unit connected to the control unit (14).

16. Device according to one of Claims 1 to 14, **characterized in that** the component-related data can be stored in a memory of a chip card (15), and **in that** they can be read out by means of a reading unit integrated in the control unit (14).

## Revendications

1. Dispositif permettant d'approcher des composants électroniques, notamment des composants SMD ou composants montés en surface, pour former une unité d'équipement, un assemblage à tiges (6) formé par une pluralité de composants étant mis à la disposition d'une unité d'approche comportant une pluralité de guides d'approche (2)
**caractérisé par le fait**
**qu'**il est prévu, pour chaque guide d'approche (2), un moyen de manoeuvre (10) qui peut être amené, en fonction de données de commande de l'approche traitées dans une unité de commande (14), dans une position de verrouillage, qui bloque le guide d'approche (2), ou dans une position de déverrouillage, qui libère le guide d'approche (2).

2. Dispositif selon la revendication 1
**caractérisé par le fait**
**que** l'unité de commande (14) comporte des moyens destinés à saisir et traiter des données relatives aux composants se rapportant à l'assemblage à tiges (6).

3. Dispositif selon la revendication 1 ou 2
**caractérisé par le fait**
**que** l'unité de commande (14) comporte des moyens destinés à constater l'affectation d'un assemblage à tiges (6) à un guide d'approche (2) prédéterminé, des données de commande de l'approche pouvant être produites à partir de la comparaison de données prédéterminées relatives à l'équipement avec des données relatives aux composants correspondant, dans chaque cas, à un assemblage à tiges (6).

4. Dispositif selon l'une des revendications 1 à 3
**caractérisé par le fait**
**que** l'unité de commande (14) peut être couplée à une pluralité de guides d'approche (2) de telle manière que les données de commande de l'approche peuvent être transmises, d'une façon séquentielle, aux moyens de manoeuvre.

5. Dispositif selon l'une des revendications 1 à 4
**caractérisé par le fait**
**que** l'unité de commande (14) comporte une électronique d'évaluation dans laquelle il est possible de vérifier si les données relatives aux composants affectées à l'assemblage à tiges (6) concordent avec les données prédéterminées relatives à l'équipement, qui sont affectées aux guides d'approche (2).

6. Dispositif selon l'une des revendications 1 à 5
**caractérisé par le fait**
**que** l'électronique d'évaluation comporte un microcontrôleur ayant une mémoire morte, dans laquelle un programme de comparaison est enregistré pour le contrôle de la concordance entre les données relatives aux composants et les données relatives à l'équipement.

7. Dispositif selon l'une des revendications 1 à 6
**caractérisé par le fait**
**que** le moyen de manoeuvre (12) est conçu comme élément de manoeuvre électromagnétique.

8. Dispositif selon l'une des revendications 1 à 7
**caractérisé par le fait**
**que** l'élément de manoeuvre (10) comporte un cylindre de verrouillage (9), qui peut glisser perpendiculairement à la longueur du guide d'approche (2), ce cylindre de verrouillage (9) se trouvant, dans la position verrouillée de l'élément de manoeuvre (10), dans une position relevée bloquant le trajet du transport (7) sur le guide d'approche (2).

9. Dispositif selon l'une des revendications 1 à 8
**caractérisé par le fait**
**que** les données de commande de l'approche produites par l'unité de commande (14) peuvent être transmises, au moyen d'une liaison électrique, aux éléments de manoeuvre (10) respectifs.

10. Dispositif selon l'une des revendications 1 à 9
**caractérisé par le fait**
**que** les éléments de manoeuvre (10) sont reliés électriquement à l'unité de commande (14) au moyen d'une réglette commune de répartition (13).

11. Dispositif selon l'une des revendications 1 à 10
**caractérisé par le fait**
**que** la réglette de répartition (13) comporte un nombre de dispositifs à enficher (19) correspondant au nombre de guides d'approche (2) et qui peuvent être reliés respectivement à des éléments enfichables (12) correspondants disposés sur les éléments de manoeuvre (10).

12. Dispositif selon l'une des revendications 1 à 11
**caractérisé par le fait**
**que** la réglette de répartition (13) est montée perpendiculairement à la longueur des guides d'approche (2) sur une extrémité de l'unité d'approche (1) opposée à l'unité d'équipement.

13. Dispositif selon l'une des revendications 1 à 12
**caractérisé par le fait**
**que** l'élément de manoeuvre (10) et/ou la réglette de répartition (13) comportent des moyens lumineux (20) de telle manière que la correspondance entre l'assemblage à tiges (6) concerné et le guide d'approche (2) correspondant peut être reconnue.

14. Dispositif selon l'une des revendications 1 à 13
**caractérisé par le fait**
**que** le moyen lumineux est conçu en tant que diode luminescente (20).

15. Dispositif selon l'une des revendications 1 à 14
**caractérisé par le fait**
**que** les données relatives aux composants sont appliquées sous forme codée, en tant que marquage par code à barres, sur l'assemblage à tiges, le marquage par code à barres pouvant être lu dans l'unité de commande (14) au moyen d'une unité de lecture reliée à l'unité de commande (14).

16. Dispositif selon l'une des revendications 1 à 14
**caractérisé par le fait**
**que** les données relatives aux composants peuvent être enregistrées dans une mémoire d'une carte à puce (15) et qu'elles peuvent être lues au moyen d'une unité de lecture intégrée dans l'unité de commande (14).
